# EUROPEAN PATENT SPECIFICATION

(11) **EP 4 307 516 B1**
(45) Date of publication and mention of the grant of the patent: **18.02.2026**
(21) Application number: 22846311.3
(22) Date of filing: 22.07.2022
(51) Int. Cl.: H02J 7/00, H02J 3/32

(54) **BATTERY MANAGEMENT APPARATUS AND METHOD**
BATTERIEVERWALTUNGSVORRICHTUNG UND -VERFAHREN
DISPOSITIF ET PROCÉDÉ DE GESTION DE BATTERIE

(30) Priority: 22.07.2021 KR 20210096729
(43) Date of publication of application: 17.01.2024
(73) Proprietor: LG Energy Solution, Ltd., Seoul 07335 (KR)
(72) Inventor: LEE, Nak Choon, Daejeon 34122 (KR); IN, Na Hye, Daejeon 34122 (KR); BACK, Seung Won, Daejeon 34122 (KR); LEE, Seung Min, Daejeon 34122 (KR); AN, Se Won, Daejeon 34122 (KR)
(74) Representative: Plasseraud IP
(86) International application number: PCT/KR2022/010834
(87) International publication number: WO 2023/003441

(56) References cited:
- EP-A1- 3 410 558
- EP-A1- 3 846 306
- EP-B1- 1 750 345
- JP-A- 2012 147 600
- JP-A- 2016 127 698
- KR-A- 20160 073 901
- KR-B1- 102 235 183
- US-A1- 2020 185 944

## Description

### [TECHNICAL FIELD]

### TECHNICAL FIELD

Embodiments disclosed herein relate to a battery management apparatus and method.

### [BACKGROUND ART]

A secondary battery is generally used as a battery pack including a battery module where a plurality of battery cells are connected to one another in series and/or in parallel. Battery packs may be managed and controlled by a battery management system in terms of their states and operations.

The battery pack controls charging/discharging power within a maximum power range, and typically does not fall beyond the set maximum power range. However, for off-grid where the battery pack is separated from a power grid, discharging with a power exceeding maximum power is required to respond to an instantaneous load. To guarantee the lifetime of the battery pack and safety of a user, the power exceeding the maximum power (hereinafter, a peak power) needs to be allowed only for a specific time. The patent application US-A-2020/185944 discloses a BMS comprising a determination unit configured to determine an off-grid state of a battery pack and a power controller configured to control a discharging power with a peak power corresponding to an available power limit of the battery pack.

### [DISCLOSURE]

### [TECHNICAL PROBLEM]

Embodiments disclosed herein aim to provide a battery management apparatus and method capable of effectively responding to off-grid and efficiently using power by controlling discharging power with peak power for a specific time in an off-grid state of a battery pack.

### [TECHNICAL SOLUTION]

A battery management apparatus according to an embodiment disclosed herein is defined by the independent claim 1, and among others it includes a determination unit configured to determine an off-grid state of a battery pack and a power controller configured to control a discharging power with a peak power that is greater than a maximum power of the battery pack in the off-grid state of the battery pack.

According to an embodiment, the power controller may be further configured to control the discharging power with the peak power when a time during which the battery pack is discharged with the maximum power or less is greater than or equal to a specific time.

According to an embodiment, the power controller may be further configured to control the battery pack not to be discharged with the peak power for a specific time when the battery pack is discharged with the peak power for a preset time.

According to an embodiment, the power controller may be further configured to control the discharging power with the peak power when a state of charge (SOC) of the battery pack is greater than or equal to a reference value.

According to an embodiment, the determination unit may be further configured to determine an off-grid state of the battery pack based on an input signal received from outside.

According to an embodiment, the determination unit may be further configured to determine the off-grid state of the battery pack when the input signal is in a high state.

According to an embodiment, the maximum power and the peak power may be values calculated based on a temperature and an SOC of the battery pack.

A battery management method according to an embodiment disclosed herein is defined by the independent claim 8 and among others it includes determining an off-grid state of a battery pack and controlling a discharging power with a peak power that is greater than a maximum power of the battery pack in the off-grid state of the battery pack.

According to an embodiment, the controlling of the discharging power may include controlling the discharging power with the peak power when a time during which the battery pack is discharged with the maximum power or less is greater than or equal to a specific time.

According to an embodiment, the controlling of the discharging power may include controlling the battery pack not to be discharged with the peak power for a specific time when the battery pack is discharged with the peak power for a preset time.

According to an embodiment, the controlling of the discharging power may include controlling the discharging power with the peak power when a state of charge (SOC) of the battery pack is greater than or equal to a reference value.

### [ADVANTAGEOUS EFFECTS]

A battery management apparatus and method according to an embodiment disclosed herein may effectively respond to off-grid and efficiently use power by controlling discharging power with peak power for a specific time in an off-grid state of a battery pack.

### [DESCRIPTION OF DRAWINGS]

FIG. 1 schematically illustrates a configuration of a battery control system including a battery management apparatus according to an embodiment disclosed herein.
FIG. 2 is a block diagram illustrating a structure of a battery management apparatus, according to an embodiment disclosed herein.
FIG. 3 is a view for describing an operation of a battery management apparatus, according to an embodiment disclosed herein.
FIG. 4 is a flowchart for describing an operation of a battery management apparatus, according to an embodiment disclosed herein.
FIG. 5 is a flowchart illustrating a battery management method according to an embodiment disclosed herein.
FIG. 6 is a block diagram showing a hardware configuration of a computing system for performing a battery management method according to an embodiment disclosed herein.

### [MODE FOR INVENTION]

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st, "2nd", "first", "second", or the like may modify various components regardless of importance, and do not limit the components. For example, a first component may be named as a second component without departing from the right scope of an embodiment disclosed herein, and similarly, the second component may be named as the first component.

Terms used in the present document are used for only describing a specific exemplary embodiment of the disclosure and may not have an intention to limit the scope of other exemplary embodiments of the disclosure. It is to be understood that the singular forms include plural references unless the context clearly dictates otherwise.

All terms including technical and scientific terms used herein have the same meaning as commonly understood by one of ordinary skill in the art to which the embodiments disclosed herein belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments disclosed herein.

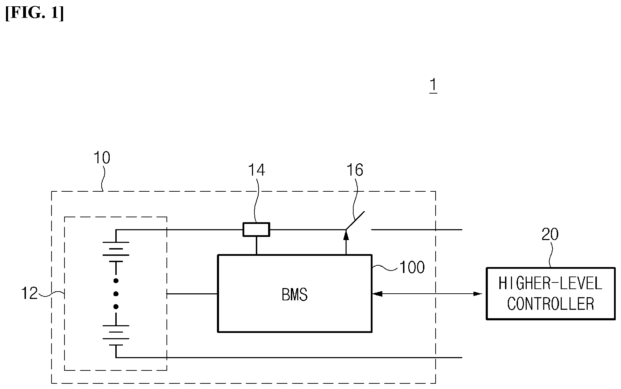

FIG. 1 schematically illustrates a configuration of a battery control system including a battery management apparatus according to an embodiment disclosed herein.

Referring to FIG. 1, a battery control system 1 may include a battery pack 10 and a higher-level controller 20. The battery pack 10 may include a battery module 12, a sensor 14, a switching unit 16, and a battery management apparatus 100. The battery pack 10 may include the battery module 12, the sensor 14, the switching unit 16, and the battery management apparatus 100 provided in plural. The battery packs 10 may be connected in series or in parallel to communicate with the higher-level controller 20 provided outside.

The battery module 12 may include one or more chargeable/dischargeable battery cells. In this case, the battery module 12 may be connected in series or in parallel. The sensor 14 may detect a voltage of the battery pack 10 or current flowing in the battery pack 10. In this case, a detected signal of current may be transmitted to the battery management apparatus 100. The switching unit 16 may be connected in series to a (+) terminal side and a (-) terminal side of the battery module 12 to control the charging/discharging current flow of the battery module 12. For example, the switching unit 16 may use at least one switch, relay, magnetic contactor, etc., according to the specifications of the battery pack 10.

The battery management apparatus 100 may monitor the voltage, current, temperature, etc., of the battery pack 10 to perform control and management to prevent overcharging and overdischarging, etc., and may be a battery management system (BMS) of the battery pack 10.

The battery management apparatus 100, which is an interface for receiving measurement values of various parameter values, may include a plurality of terminals and a circuit, etc., connected to the terminals to process received values. The battery management apparatus 100 may control ON/OFF of the switching unit 16, e.g., a switch, a relay, a contactor, etc., and may be connected to the plurality of battery modules 12 to monitor the state of battery cells.

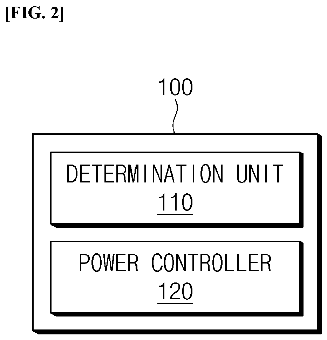

Meanwhile, the battery management apparatus 100 disclosed herein may control charging/discharging power of the battery pack 10 based on a voltage of the battery pack 10. For example, the battery management apparatus 100 may calculate maximum power and peak power of the battery pack. The battery management apparatus 100 may control the discharging power of the battery pack 10 according to the calculated maximum power and peak power. The configuration of the battery management apparatus 100 will be described in detail with reference to FIG. 2.

The higher-level controller 20 may transmit various control signals regarding the battery module 12 to the battery management apparatus 100. For example, the higher-level controller 20 may be an inverter system. Thus, the battery management apparatus 100 may also be controlled in terms of an operation thereof based on a signal applied from the higher-level controller 20. The higher-level controller 20 may be connected to the battery management apparatus 100 through a direct current DC/DC port of the battery pack 10.

Meanwhile, the battery cell according to the present disclosure may be included in the battery module 12 used for an electric vehicle. However, the battery pack 10 of FIG. 1 is not limited to such a purpose, and for example, a battery rack of an energy storage system (ESS) may be included in place of the battery pack 10 of FIG. 1.

FIG. 2 is a block diagram illustrating a structure of a battery management apparatus, according to an embodiment disclosed herein.

Referring to FIG. 2, the battery management apparatus 100 according to an embodiment disclosed herein may include a determination unit 110 and a power controller 120.

The determination unit 110 may determine an off-grid state of the battery pack 10. In this case, the determination unit 110 may determine the off-grid state of the battery pack 10 based on an input signal received from outside. For example, the determination unit 110 may determine that the battery pack 10 is in the off-grid state when the input signal is in a high state (e.g., an input voltage is greater than or equal to a threshold value).

For instance, the determination unit 110 may determine the off-grid state of the battery pack 10 based on a voltage signal input from a higher-level controller (e.g., an inverter system) through the DC/DC port of the battery pack described with reference to FIG. 1. In this case, the input signal may be a signal for driving a black-start function of the battery pack 10.

The power controller 120 may control a discharging power with a peak power greater than a maximum power for charging/discharging of the battery pack 10 in the off-grid state of the battery pack 10. Herein, the maximum power and the peak power of the battery pack 10 may be values calculated based on the temperature and state of charge (SOC) of the battery pack 10.

More specifically, the power controller 120 may control the discharging power of the battery pack 10 for a preset time (e.g., 3 seconds) with the peak power when a preset operating condition is satisfied. In this case, the power controller 120 may control the discharging power with the peak power when a time during which the battery pack 10 is discharged with the maximum power or less is greater than or equal to a specific time (e.g., 180 seconds).

When the power controller 120 discharges the battery pack 10 with the peak power for a preset time, the power controller 120 may control the battery pack 10 so as not to be discharged with the peak power for a subsequent specific time to secure the lifespan of the battery pack 10 and guarantee safety of a user.

The power controller 120 may control the discharging power with the peak power when the SOC of the battery pack 10 is greater than or equal to a reference value. For example, the power controller 120 may perform discharging with the peak power when the SOC of the battery pack 10 is at least greater than or equal to 30%. However, a peak power control condition of the power controller 120 is not limited thereto, and various factors such as a voltage, a temperature, a capacity, a state of health (SOH), etc., may be included in a control condition.

As such, the battery management apparatus 100 according to an embodiment disclosed herein may effectively respond to off-grid and efficiently use power by controlling discharging power with peak power for a specific time in the off-grid state of the battery pack 10.

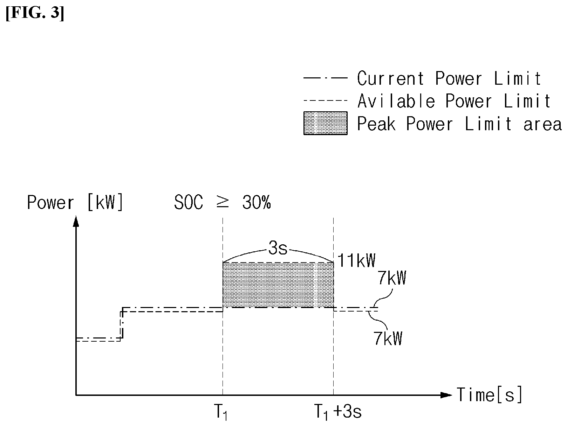

FIG. 3 is a view for describing an operation of a battery management apparatus, according to an embodiment disclosed herein.

Referring to FIG. 3, a horizontal axis indicates a time (second), and a vertical axis indicates a discharging power (kW) of the battery pack 10. Each graph shown in FIG. 3 indicates a maximum power (a current power limit) (e.g., 7 kW) and a peak power (an available power limit) (e.g., 11 kW) of the battery pack 10.

As shown in FIG. 3, the battery management apparatus 100 according to an embodiment disclosed herein may perform discharging up to the peak power of 11 kW in the off-grid state after the elapse of a specific time (e.g., 180 seconds) from discharging of the battery pack 10 within the maximum power of 7 kW. The battery management apparatus 100 may perform discharging with the peak power for a preset time (e.g., 3 seconds) and then perform again discharging within the maximum power.

The battery management apparatus 100 according to an embodiment disclosed herein may perform discharging based on the peak power after the elapse of a specific time (e.g., 180 seconds) from discharging with the peak power for a preset time.

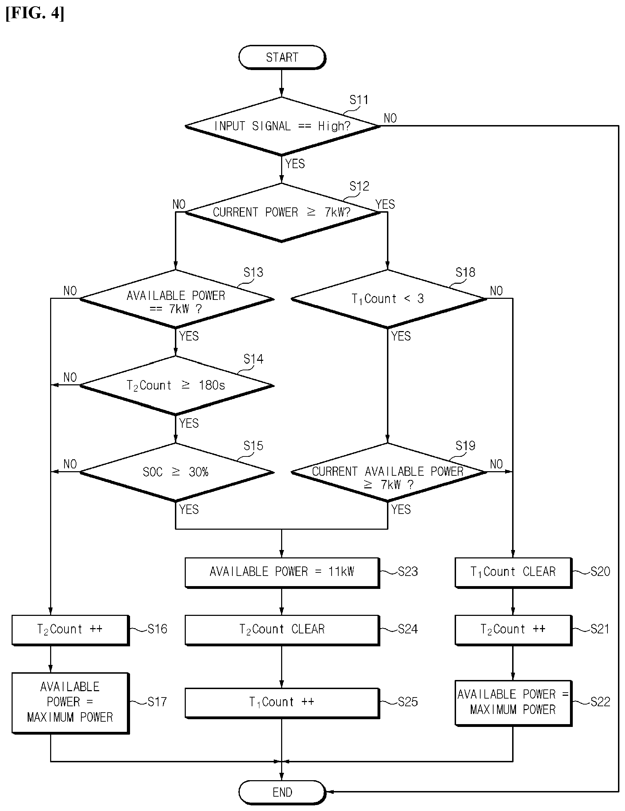

FIG. 4 is a flowchart for describing an operation of a battery management apparatus, according to an embodiment disclosed herein.

Referring to FIG. 4, an example will be described where a maximum power and a peak power of the battery management apparatus 100 according to an embodiment disclosed herein are 7 kW and 11 kW, respectively. However, the maximum power and peak power of the battery management apparatus 100 disclosed herein are not limited thereto. In FIG. 4, T₁ indicates a time for which the battery pack 10 is discharged with the peak power, and T₂ indicates a time for which the battery pack 10 is discharged with the maximum power or less.

First, the battery management apparatus 100 may determine whether an input signal applied to the battery pack 10 is high or not, in operation S11. That is, when the input signal is in the high state (e.g., the input voltage is greater than or equal to the threshold value) in operation S11, it may be determined that the battery pack 10 is in the off-grid state.

It is determined in operation S12 whether the current discharging power of the battery pack 10 is greater than or equal to 7 kW. When the discharging power of the battery pack 10 is less than 7 kW (NO), it is determined whether the current available power of the battery pack 10 is a maximum power of 7 kW in operation S13. When the available power of the battery pack 10 is 7 kW (YES), it is determined whether T₂ is greater than or equal to a specific time (180 seconds in the example of FIG. 4) in operation S14. When T₂ is greater than or equal to 180 seconds (YES), it is determined whether the SOC of the battery pack 10 is greater than or equal to a reference value (30% in the example of FIG. 4) in operation S15.

When the SOC of the battery pack 10 is greater than or equal to 30% (YES) in operation S15, the available maximum power of the battery pack 10 may be set to a peak power of 11 kW in operation S23. However, when any one of conditions of operations S13 to S15 is not satisfied (NO), a count of T₂ may be added in operation S16 and the available power may be set to a maximum power of 7 kW in operation S17.

When the discharging power of the battery pack 10 is greater than or equal to 7 kW (YES) in operation S12, it is determined whether T₁ is less than a preset time (3 seconds in the example of FIG. 4), in operation S18. When T₁ is less than 3 seconds (YES), it is determined whether the current available power is greater than or equal to 7 kW in operation S 19. When the available power of the battery pack 10 is greater than or equal to 7 kW (YES), the available maximum power of the battery pack 10 may be set to a peak power of 11 kW in operation S23. On the other hand, when the battery pack 10 satisfies none of conditions of operations S18 and S19 (NO), the count of T₁ is initialized in operation S20 and a count of T₂ is added in operation S21. The available power of the battery pack 10 is set to the maximum power in operation S22.

Meanwhile, when the available power of the battery pack 10 is set to a peak power of 11 kW in operation S23, the count of T₂ may be initialized in operation S24 and the count of T₁ may be added in operation S25. As such, the battery management apparatus 100 according to an embodiment disclosed herein may perform discharging with the peak power for a preset time when the SOC of the battery pack 10 is greater than or equal to the reference value after the elapse of a specific time from discharging within the maximum power, thereby efficiently controlling the power of the battery pack 10 in off-grid.

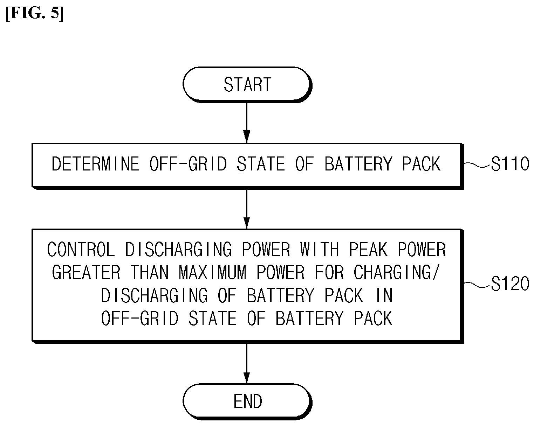

FIG. 5 is a flowchart illustrating a battery management method according to an embodiment disclosed herein.

Referring to FIG. 5, a battery management method according to an embodiment disclosed herein may determine the off-grid state of the battery pack in operation S110. In this case, the off-grid state of the battery pack 10 may be determined based on an input signal received from outside, in operation S110. For example, in operation S110, when the input signal is in the high state (e.g., the input voltage is greater than or equal to the threshold value), it may be determined that the battery pack 10 is in the off-grid state.

For instance, in operation S110, the off-grid state of the battery pack 10 may be determined based on a voltage signal input from a higher-level controller (e.g., an inverter system) through the DC/DC port of the battery pack described with reference to FIG. 1. In this case, the input signal may be a signal for driving a black-start function of the battery pack 10.

In operation S120, the discharging power may be controlled with the peak power greater than the maximum power for charging/discharging of the battery pack in the off-grid state of the battery pack. Herein, the maximum power and the peak power of the battery pack 10 may be values calculated based on the temperature and SOC of the battery pack 10.

More specifically, in operation S120, the discharging power of the battery pack 10 may be controlled for a preset time (e.g., 3 seconds) with the peak power when a preset operating condition is satisfied. In this case, in operation S120, the discharging power may be controlled with the peak power when a time during which the battery pack 10 is discharged with the maximum power or less is greater than or equal to a specific time (e.g., 180 seconds).

In operation S120, when the power controller 120 discharges the battery pack 10 with the peak power for a preset time, the power controller 120 may control the battery pack 10 so as not to be discharged with the peak power for a subsequent specific time to secure the lifespan of the battery pack 10 and guarantee safety of a user.

In operation S120, the discharging power may be controlled with the peak power when the SOC of the battery pack 10 is greater than or equal to a reference value. For example, in operation S120, discharging may be performed with the peak power when the SOC of the battery pack 10 is at least greater than or equal to 30%. However, a peak power control condition in operation S120 is not limited thereto, and various factors such as a voltage, a temperature, a capacity, an SOH, etc., may be included in a control condition.

As such, the battery management method according to an embodiment disclosed herein may effectively respond to off-grid and efficiently use power by controlling discharging power with peak power for a specific time in an off-grid state of a battery pack.

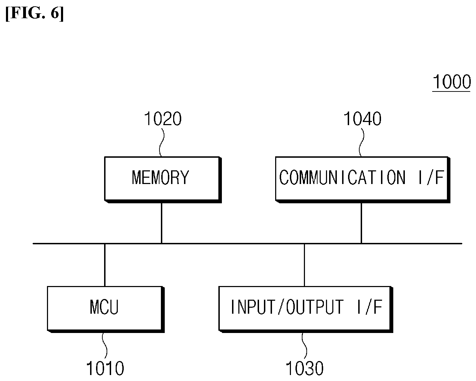

FIG. 6 is a block diagram showing a hardware configuration of a computing system for performing a battery management method according to an embodiment disclosed herein.

Referring to FIG. 6, a computing system 1000 according to an embodiment disclosed herein may include an MCU 1010, a memory 1020, an input/output interface (I/F) 1030, and a communication I/F 1040.

The MCU 1010 may be a processor that executes various programs (e.g., a battery maximum/peak power calculation program, a power control program for a battery pack, etc.) stored in the memory 1020, processes various data including a link, a voltage, a charging/discharging power, etc., of a battery pack through these programs, and executes the above-described functions of the battery management apparatus shown in FIG. 2.

The memory 1020 may store various programs regarding maximum and peak power calculation, charging/discharging power control of the battery pack, etc. Moreover, the memory 1020 may store various data such as voltage and power of the battery pack, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a program for power calculation and charging/discharging power control of the battery pack, various data, etc., may be transmitted and received to and from a separately provided external server through the communication I/F 1040.

As such, a computer program according to an embodiment disclosed herein may be recorded in the memory 1020 and processed by the MCU 1010, thus being implemented as a module that performs functions shown in FIG. 2.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery management apparatus (100) comprising:
a determination unit (110) configured to determine an off-grid state of a battery pack (10); and
a power controller (120) configured to control a discharging power with a peak power for a preset time, the peak power corresponding to an available power limit of the battery pack, which is greater than a maximum power corresponding to a current power limit of the battery pack in the off-grid state, when the three following preset operating conditions are satisfied:
- the state of charge, SOC, of the battery pack is greater than or equal to a reference value;
- a time during which the battery pack is discharged with the maximum power or less is greater than or equal to a specific time;
- the battery pack has not been discharged with a peak power for a subsequent specific time after a peak power discharge.

2. The battery management apparatus of claim 1, wherein the power controller is further configured to control the discharging power with the peak power when the first time during which the battery pack is discharged with the maximum power or less is greater than or equal to a specific time.

3. The battery management apparatus of claim 1, wherein the power controller is further configured to control the battery pack not to be discharged with the peak power for a specific time when the battery pack is discharged with the peak power for the preset time.

4. The battery management apparatus of claim 1, wherein the power controller is further configured to control the discharging power with the peak power when the state of charge, SOC, of the battery pack is greater than or equal to a reference value.

5. The battery management apparatus of claim 1, wherein the determination unit is further configured to determine an off-grid state of the battery pack based on an input signal received from outside.

6. The battery management apparatus of claim5, wherein the determination unit is further configured to determine the off-grid state of the battery pack when the input signal is in a high state.

7. The battery management apparatus of claim 1, wherein the maximum power and the peak power are values calculated based on a temperature and an SOC of the battery pack.

8. A battery management method comprising:
determining an off-grid state of a battery pack; and
controlling a discharging power with a peak power for a preset time, the peak power corresponding to an available power limit of the battery pack, which is greater than a maximum power corresponding to a current power limit of the battery pack of the battery pack in the off-grid state, when the three following preset operating conditions are satisfied:
- the state of charge, SOC, of the battery pack is greater than or equal to a reference value;
- a time during which the battery pack is discharged with the maximum power or less is greater than or equal to a specific time;
- the battery pack has not been discharged with a peak power for a subsequent specific time after a peak power discharge.

9. The battery management method of claim8, wherein the controlling of the discharging power comprises controlling the discharging power with the peak power when the first time during which the battery pack is discharged with the maximum power or less is greater than or equal to a specific time.

10. The battery management method of claim 8, wherein the controlling of the discharging power comprises controlling the battery pack not to be discharged with the peak power for a specific time when the battery pack is discharged with the peak power for the preset time.

11. The battery management method of claim 8, wherein the controlling of the discharging power comprises controlling the discharging power with the peak power when the state of charge, SOC, of the battery pack is greater than or equal to a reference value.

## Patentansprüche

1. Batteriemanagementvorrichtung (100), umfassend:
eine Ermittlungseinheit (110), die dazu eingerichtet ist, einen netzunabhängigen Zustand eines Batteriepacks (10) zu ermitteln; und
eine Leistungssteuerung (120), die dazu eingerichtet ist, eine Entladeleistung mit einer Spitzenleistung für eine vorbestimmte Zeit zu steuern, wobei die Spitzenleistung einer verfügbaren Leistungsgrenze des Batteriepacks entspricht, die größer als eine maximale Leistung ist, die einer Stromleistungsgrenze des Batteriepacks im netzunabhängigen Zustand entspricht, wenn die folgenden drei vorbestimmten Betriebsbedingungen erfüllt sind:
- der Ladezustand, SOC, des Batteriepacks ist größer als oder gleich einem Referenzwert;
- eine Zeit, in der der Batteriepack mit der maximalen Leistung oder weniger entladen wird, ist größer als oder gleich einer bestimmten Zeit;
- der Batteriepack ist nach einer Spitzenleistungsentladung nicht mit einer Spitzenleistung für eine nachfolgende, bestimmte Zeit entladen worden.

2. Die Batteriemanagementvorrichtung nach Anspruch 1, wobei die Leistungssteuerung ferner dazu eingerichtet ist, die Entladeleistung mit der Spitzenleistung zu steuern, wenn die erste Zeit, in welcher der Batteriepack mit der maximalen Leistung oder weniger entladen wird, größer als oder gleich einer bestimmten Zeit ist.

3. Die Batteriemanagementvorrichtung nach Anspruch 1, wobei die Leistungssteuerung ferner dazu eingerichtet ist, zu steuern, dass der Batteriepack nicht mit der Spitzenleistung für eine bestimmte Zeit entladen wird, wenn der Batteriepack für die vorbestimmte Zeit mit der Spitzenleistung entladen wird/wurde.

4. Die Batteriemanagementvorrichtung nach Anspruch 1, wobei die Leistungssteuerung ferner dazu eingerichtet ist, die Entladeleistung mit der Spitzenleistung zu steuern, wenn der Ladezustand, SOC, des Batteriepacks größer als oder gleich einem Referenzwert ist.

5. Die Batteriemanagementvorrichtung nach Anspruch 1, wobei die Ermittlungseinheit ferner dazu eingerichtet ist einen netzunabhängigen Zustand des Batteriepacks auf der Grundlage eines von außen empfangenen Eingangssignals zu ermitteln.

6. Die Batteriemanagementvorrichtung nach Anspruch 5, wobei die Ermittlungseinheit ferner dazu eingerichtet ist den netzunabhängigen Zustand des Batteriepacks zu ermitteln, wenn sich das Eingangssignal in einem hohen Zustand befindet.

7. Die Batteriemanagementvorrichtung nach Anspruch 1, wobei die maximale Leistung und die Spitzenleistung Werte sind, die auf der Grundlage einer Temperatur und eines SOC des Batteriepacks berechnet sind.

8. Ein Batteriemanagementverfahren, umfassend:
Ermitteln eines netzunabhängigen Zustands eines Batteriepacks; und
Steuern einer Entladeleistung mit einer Spitzenleistung für eine vorbestimmte Zeit, wobei die Spitzenleistung einer verfügbaren Leistungsgrenze des Batteriepacks entspricht, die größer als eine maximale Leistung ist, die einer Stromleistungsgrenze des Batteriepacks des Batteriepacks im netzunabhängigen Zustand entspricht, wenn die drei folgenden vorbestimmten Betriebsbedingungen erfüllt sind:
- der Ladezustand, SOC, des Batteriepacks ist größer als oder gleich einem Referenzwert;
- eine Zeit, in der der Batteriepack mit der maximalen Leistung oder weniger entladen wird, ist größer als oder gleich einer bestimmten Zeit;
- der Batteriepack ist nach einer Spitzenleistungsentladung nicht mit einer Spitzenleistung für eine nachfolgende, bestimmte Zeit entladen worden.

9. Das Batteriemanagementverfahren nach Anspruch 8, wobei das Steuern der Entladeleistung ein Steuern der Entladeleistung mit der Spitzenleistung umfasst, wenn die erste Zeit, in welcher der Batteriepack mit der maximalen Leistung oder weniger entladen wird, größer als oder gleich einer bestimmten Zeit ist.

10. Das Batteriemanagementverfahren nach Anspruch 8, wobei das Steuern der Entladeleistung ein Steuern des Batteriepacks umfasst, sodass dieser für eine bestimmte Zeit nicht mit der Spitzenleistung entladen wird, wenn der Batteriepack für die vorbestimmte Zeit mit der Spitzenleistung entladen wird/wurde.

11. Das Batteriemanagementverfahren nach Anspruch 8, wobei das Steuern der Entladeleistung ein Steuern der Entladeleistung mit der Spitzenleistung umfasst, wenn der Ladezustand, SOC, des Batteriepacks größer als oder gleich einem Referenzwert ist.

## Revendications

1. Appareil de gestion de batterie (100) comprenant :
une unité de détermination (110) configurée pour déterminer un état hors réseau d'un bloc-batterie (10) ; et
un dispositif de commande de puissance (120) configuré pour commander une puissance de décharge à une puissance de crête pendant une durée prédéfinie, la puissance de crête correspondant à une limite de puissance disponible du bloc-batterie, qui est supérieure à une puissance maximale correspondant à une limite de puissance actuelle du bloc-batterie à l'état hors réseau, lorsque les trois conditions de fonctionnement prédéfinies suivantes sont satisfaites :
- l'état de charge, SOC, du bloc-batterie est supérieur ou égal à une valeur de référence ;
- une durée pendant laquelle le bloc-batterie est déchargé à la puissance maximale ou une puissance inférieure est supérieure ou égale à une durée spécifique ;
- le bloc-batterie n'a pas été déchargé à une puissance de crête pendant une durée spécifique ultérieure après une décharge à puissance de crête.

2. Appareil de gestion de batterie selon la revendication 1, dans lequel le dispositif de commande de puissance est en outre configuré pour commander la puissance de décharge à la puissance de crête lorsque la première durée pendant laquelle le bloc-batterie est déchargé à la puissance maximale ou une puissance inférieure est supérieure ou égale à une durée spécifique.

3. Appareil de gestion de batterie selon la revendication 1, dans lequel le dispositif de commande de puissance est en outre configuré pour commander le bloc-batterie afin qu'il ne soit pas déchargé à la puissance de crête pendant une durée spécifique lorsque le bloc-batterie est déchargé à la puissance de crête pendant la durée prédéfinie.

4. Appareil de gestion de batterie selon la revendication 1, dans lequel le dispositif de commande de puissance est également configuré pour commander la puissance de décharge à la puissance de crête lorsque l'état de charge, SOC, du bloc-batterie est supérieur ou égal à une valeur de référence.

5. Appareil de gestion de batterie selon la revendication 1, dans lequel l'unité de détermination est en outre configurée pour déterminer un état hors réseau du bloc-batterie sur la base d'un signal d'entrée reçu de l'extérieur.

6. Appareil de gestion de batterie selon la revendication 5, dans lequel l'unité de détermination est en outre configurée pour déterminer l'état hors réseau du bloc-batterie lorsque le signal d'entrée est dans un état élevé.

7. Appareil de gestion de batterie selon la revendication 1, dans lequel la puissance maximale et la puissance de crête sont des valeurs calculées sur la base d'une température et d'un SOC du bloc-batterie.

8. Procédé de gestion de batterie comprenant :
la détermination d'un état hors réseau d'un bloc-batterie ; et
la commande d'une puissance de décharge à une puissance de crête pendant une durée prédéfinie, la puissance de crête correspondant à une limite de puissance disponible du bloc-batterie, qui est supérieure à une puissance maximale correspondant à une limite de puissance actuelle du bloc-batterie à l'état hors réseau, lorsque les trois conditions de fonctionnement prédéfinies suivantes sont satisfaites :
- l'état de charge, SOC, du bloc-batterie est supérieur ou égal à une valeur de référence ;
- une durée pendant laquelle le bloc-batterie est déchargé à la puissance maximale ou une puissance inférieure est supérieure ou égale à une durée spécifique ;
- le bloc-batterie n'a pas été déchargé à une puissance de crête pendant une durée spécifique ultérieure après une décharge à puissance de crête.

9. Procédé de gestion de batterie selon la revendication 8, dans lequel la commande de la puissance de décharge comprend la commande de la puissance de décharge à la puissance de crête lorsque la première durée pendant laquelle le bloc-batterie est déchargé à la puissance maximale ou une puissance inférieure est supérieure ou égale à une durée spécifique.

10. Procédé de gestion de batterie selon la revendication 8, dans lequel la commande de la puissance de décharge comprend la commande du bloc-batterie afin qu'il ne soit pas déchargé à la puissance de crête pendant une durée spécifique lorsque le bloc-batterie est déchargé à la puissance de crête pendant la durée prédéfinie.

11. Procédé de gestion de batterie selon la revendication 8, dans lequel la commande de la puissance de décharge comprend la commande de la puissance de décharge à la puissance de crête lorsque l'état de charge, SOC, du bloc-batterie est supérieur ou égal à une valeur de référence.
